# EUROPEAN PATENT APPLICATION

(11) **EP 3 584 725 A1**
(43) Date of publication of application: **25.12.2019**
(21) Application number: 19180970.6
(22) Date of filing: 18.06.2019
(51) Int. Cl.: G06F 17/50, G05D 1/00

(54) **ACCELERATED VIRTUAL AUTONOMOUS VEHICLE TESTING SYSTEM IN REAL ROAD CONDITIONS**

(30) Priority: 18.06.2018 TR 201808608
(71) Applicant: Istanbul Okan Üniversitesi, Istanbul (TR)
(72) Inventor: ALANKUS, ORHAN BEHIC, ISTANBUL (TR)
(74) Representative: Sevinç, Cenk

(57) **Abstract**

The present invention relates to an accelerated virtual autonomous vehicle testing system in real road conditions, that ensures to layer camera data taken by camera and sensors placed on vehicle in different road, air conditions and traffic states according to speed and direction of moving objects by means of using image processing methods and to save every layer. The invention particularly relates an accelerated virtual autonomous vehicle testing systems in read road conditions, that processes speed and direction differences subsequent to data comparison carried out by the system and tests the autonomous vehicle software by means of playing film layers calculated according to different speeds. The systems send sensor data to environment sensor and interpreter system (Sensor Fusion System-SFS) and transmits the received data to the autonomous vehicle control systems. Thus, after giving gas, brake and steering instructions, it ensures to compare said instructions with driver instructions.

## Description

### Related Technical Field

The present invention relates to an accelerated virtual autonomous vehicle testing system in real road conditions, that ensures to layer camera data taken by camera and sensors placed on vehicle in different road, air conditions and traffic states according to speed and direction of moving objects by means of using image processing methods and to save every layer.

The invention particularly relates an accelerated virtual autonomous vehicle testing systems in real road conditions, that processes speed and direction differences subsequent to data comparison carried out by the system and tests the autonomous vehicle software by means of playing film layers calculated according to different speeds. The systems send sensor data to environment sensor and interpreter system (Sensor Fusion System-SFS) and transmits the received data to the autonomous vehicle control systems. Thus, after giving gas, brake and steering instructions, it ensures to compare said instructions with driver instructions.

### State of the Art

Transportation is the leading one of the most important factors. Together with the technology developed, developments in the transportation are varied and developed within this scope. One of the greatest problems in transportation is human-originated accidents and accordingly, loss of life and property. Technology is exploited widely so as to minimize said human factor. The most developed example thereof is autonomous vehicles.

Autonomous vehicles, also known as driverless vehicles, are vehicles capable of moving automatically without human interference by means of its various sensors so as to sense the environment. Manufacturing those vehicles and the most important factor after its manufacture is to test those vehicles before putting in traffic. Various simulation systems are used for the test. It is quite hard to test safely autonomous vehicles. Their verification systems are not developed yet. Traffic scenarios are formed in computer and autonomous vehicle software created according to these scenarios are tested.

The patent document numbered **"**2016/20283**"** has been examined within the result of the preliminary survey conducted in the state of the art. Abstract of the invention subjected to the application states that "the invention relates to a control system that is used in the testing phase of vehicles in automotive sector, controls vehicles without needing user to interfere with any components excluding steering and commands automatically the vehicles by means of vehicles gas pedal and vehicles brakes, wherein it comprises a mechanical unit comprised of gas activator applying force on the vehicles gas pedal in the directions (+x) or (-x) and brake activator applying force on the vehicle brake pedal in the directions (+x) or (-x); a speed sensor reading the current speed of vehicle; sensor processor processing information coming from the speed sensor; electronic unit formed from the control computer that provides speed control of the vehicle according to the instant vehicle speed measurements received from the mechanical unit and sensor processor.

The patent document numbered **"**EP3206008**"** has been examined within the result of the preliminary survey conducted in the state of the art. The invention subjected to the application relates to an automotive test system comprising a data input port to receive sensor input data and a data processing unit equipped with a data output port to transmit processed data. The system further comprises a data collection unit, sensor system and a sensor unit with an electronic system to catch sensor data.

The patent document numbered **"**US2017132117**"** has been examined within the result of the preliminary survey conducted in the state of the art. The invention subjected to the application relates to a test planning system for autonomous vehicle that produces automatically test scenarios for autonomous vehicles by using data collected from vehicles put in the public highway traffic. The system further comprises a centralized database designed to question the group of all test cases.

In systems used in the state of art, traffic scenarios are prepared in computer and autonomous vehicle software programmed according to said scenarios are tested. Herein, both vehicle and sensors are created in simulation. Furthermore, it takes too much time to create scenarios and it is possible that these scenarios do not reflect real cases. It is not only too dangerous to test on road but also takes too much time.

As a result, due to the aforementioned drawbacks and insufficiency of the existing solutions regarding the subject matter, the need for a development in the related technical field has arisen.

### Objects of the Invention

Main object of the invention is to ensure that data taken by driver from autonomous vehicle sensors while driving in real road conditions are replayed and given to the sensor fusion system and control system and that steering, brake and gas instructions are given complying with decisions of the control system. Thus, data taken by means of real camera and sensors on the vehicle from the vehicle driven safely by drivers in traffic, different roads and different weather conditions are processed by the autonomous vehicle control system in the simulation system and testing of the autonomous vehicle will be carried in real medium swiftly.

Another object of the invention is to constitute differences between sensor data taken based on real road conditions and real drive by means of taking videos of roads and conditions and saving all sensor data. Thus, autonomous vehicles are tested in real road conditions.

Another object of the invention is to layer footages according to the speed and direction of moving objects by means of image-processing methods. Thus, further recording is carried out layer by layer.

Further object of the invention is to ensure that gas, brake and steering instructions given to the system are compared with the driver's instruction and to process the speed and direction difference therebetween. Accordingly, film layers calculated based on different speeds are separately played depending on said differences.

The structural and characteristic aspects and all the advantages of the present invention will be more clearly understood by means of following figures and the detailed description written with references to these figures. Therefore, while making an evaluation, these figures and the detailed description should be taken into account.

### Description of the Invention

The inventive accelerated virtual autonomous vehicle testing system in real road conditions, in general terms, comprises various sensors, cameras, data collection device, sensor fusion system, control unit and processing unit. The inventive accelerated virtual autonomous vehicle testing system in real road conditions comprises above-mentioned components and the corresponding operating methods.

Sensors are positioned on the autonomous vehicle and receive environmental data. Cameras are positioned on the autonomous vehicle and receive environmental footage. Data collecting device collects and saves road data received from sensors and cameras. Sensor fusion system transmits the data received to the control unit, after sensor data are converted by a converter into an appropriate data format. The control unit provides gas, brake and steering instructions depending on the data received from the sensor fusion system. Processing unit processes speed and direction differences by comparing gas, brake and steering instructions provided by the control unit with driver's instructions and accordingly, film layers calculated based on different speeds are played separately depending on said differences.

Operation method of the inventive accelerated virtual autonomous vehicle testing system in real road conditions is comprised of the process steps of:
∘ Layering camera data taken by camera and sensors placed on the autonomous vehicle in different road, air conditions and traffic states according to speed and direction of moving objects by means of using image processing methods and to save every layer,
∘ Performing separately recording of each layer,
∘ Transmitting firstly sensor data to the sensor fusion system (environment sensor and interpreter system) by means of converter,
∘ Transmitting the data received by the sensor fusion system to the control unit,
∘ Forming gas, brake and steering instructions by the control unit depending on the data received by the control unit,
∘ Processing speed and direction differences by comparing gas, brake and steering instructions formed by the control unit with driver's instructions by means of the processing unit,
∘ Calculating speed and direction differences processed by the processing unit depending on the different speeds,
∘ Testing the autonomous vehicle in real road conditions by means of playing separately film layers depending on the calculated differences.

Driver drives autonomous vehicle in various road and different traffic conditions. All data coming from sensors are saved on the vehicle. In the meantime, real footage is saved as well. Afterwards, the footage is layered depending on the speed and directions of moving objects by means of image processing methods. Further, recording is carried out layer by layer. In lab environment, the sensor image and data received are given to the sensor fusion system by means of a converter and then, environment analysis data from the sensor fusion system are transmitted to the control unit. Autonomous vehicle control unit provides gas, brake and steering instructions depending on its own interior application. These instructions are compared with driver's instructions and speed and direction differences are processed. Accordingly, film layers calculated based on different speeds are separately played depending on said differences. In this way, the film is played till its end and the autonomous vehicle is tested in real road conditions.

## Claims

1. Accelerated virtual autonomous vehicle testing system in real road conditions that tests software of autonomous vehicles, **characterized by** comprising:
• **Sensors** positioned on the autonomous vehicle and receiving environmental data,
• **Cameras** positioned on the autonomous vehicle and receiving environmental footage,
• **Data collecting device** collecting and saving road data received from sensors and cameras,
• **Sensor fusion system** transmitting the data received to the control unit, after sensor data are converted by a converter into an appropriate data format,
• **Control unit** providing gas, brake and steering instructions depending on the data received from the sensor fusion system,
• **Processing unit** processing speed and direction differences by comparing gas, brake and steering instructions provided by the control unit with driver's instructions and accordingly, playing separately film layers calculated based on different speeds depending on said differences.

2. Accelerated virtual autonomous vehicle testing system in real road conditions according to Claim 1, **characterized by** comprising the process steps of;
- Layering camera data taken by camera and sensors placed on the autonomous vehicle in different road, air conditions and traffic states according to speed and direction of moving objects by means of using image processing methods and to save every layer,
- Performing separately recording of each layer,
- Transmitting firstly sensor data to the sensor fusion system (environment sensor and interpreter system) by means of converter,
- Transmitting the data received by the sensor fusion system to the control unit,
- Forming gas, brake and steering instructions by the control unit depending on the data received by the control unit,
- Processing speed and direction differences by comparing gas, brake and steering instructions formed by the control unit with driver's instructions by means of the processing unit,
- Calculating speed and direction differences processed by the processing unit depending on the different speeds,
- Testing the autonomous vehicle in real road conditions by means of playing separately film layers depending on the calculated differences.
